# EUROPEAN PATENT APPLICATION

(11) **EP 3 514 254 A1**
(43) Date of publication of application: **24.07.2019**
(21) Application number: 18382027.3
(22) Date of filing: 18.01.2018
(51) Int. Cl.: C23C 4/08, B05B 1/00, H05K 3/14, C23C 4/134

(54) **METHOD FOR MANUFACTURING AN ELECTRONIC ASSEMBLY, ELECTRONIC ASSEMBLY AND LIGHTING DEVICE**

(71) Applicant: Valeo Iluminacion, 23600 Martos (ES)
(72) Inventor: TEBA, Daniel, 23600 MARTOS (ES); MEDINA, Manuel-Jesus, 23600 MARTOS (ES); GUZMAN, Alfonso-Manuel, 23600 MARTOS (ES); MARTINEZ-REQUENA, Francisco, 23600 MARTOS (ES); PADILLA, Pedro, 23600 MARTOS (FR)

(57) **Abstract**

This invention provides a method for manufacturing an electronic assembly (1), the method comprising the steps of providing a flexible substrate (2) and depositing a conductive track (3) by direct deposition on the flexible substrate (2).

## Description

### TECHNICAL FIELD

The present invention belongs to the field of electronic assemblies comprising conductive tracks directly deposited on a plastics substrate.

### STATE OF THE ART

Automotive lighting devices require the arrangement of electric circuits to feed light sources. As every arrangement related to the automotive industry, space and cost need to be minimized, which is not normally the case when conventional printed circuit boards (PCB) are used in automotive lighting devices.

Sometimes, the power source and the light source are located in different modules, and a relative displacement between them must be allowed in order to regulate the position of the lighting module with respect to the housing.

Wire bonding and ribbon bonding are usually employed to electrically connect two points which are not arranged in the same substrate. However, these methods are not always advisable, due to their fragility. An alternative to these methods is the use of expensive flexible printed circuit boards, which provide a greater design flexibility, but at the expense of a higher cost.

### DESCRIPTION OF THE INVENTION

The invention provides a solution for this problem by means of a method for manufacturing an electronic assembly according to claim 1, an electronic assembly according to claim 12 and a lighting device according to claim 13. Preferred embodiments of the invention are defined in dependent claims.

In an inventive aspect, the invention provides a method for manufacturing an electronic assembly, the method comprising the steps of:
providing a flexible substrate; and
depositing a conductive track by direct deposition on the flexible substrate
wherein the flexible substrate is flexible in the sense that two of its edges may be put together without causing a plastic deformation in said flexible substrate.

Direct deposition of a conductive track on a plastics substrate should be construed as forming the final shape of the conductive track on the plastics substrate without the need for removing metal or for any other intermediate element, such as a mask, an electrolyte or any other chemical bath or a photosensitive film. The conductive track is just directly placed on the plastics substrate.

This method advantageously achieves the electric connection of a semiconductor light source to a conductive track directly deposited on a three-dimensional plastics substrate. In some particular embodiments, the plastics substrate is a three-dimensional plastics substrate.

Directly depositing a conductive track on a plastics substrate normally supposes substantial cost savings, mainly due to the fact that a dedicated printed circuit board need not be provided. Therefore, other integral parts of the device to be controlled with the electronic assembly can be taken advantage of to play the role of substrate for the conductive track.

Furthermore, the process of direct deposition of the conductive track usually implies shorter manufacturing times and conductive material savings - in contrast to most PCB manufacturing methods, there is no need for removing regions of conductive material or for using an additional product, such as an electrolyte, to define the conductive track.

In some particular embodiments, the step of depositing a conductive track by direct deposition on the flexible substrate comprises the steps of:
- applying metal dust within a plasma flow created by an electric power, wherein the metal dust is fed to the plasma flow at a rate comprised between 0.08 and 0.095 g/s, the electric power generated to create a plasma flow is comprised between 200 and 3500 W and the electric power is generated at a frequency comprised between 20 and 80 kHz;
- ejecting, by means of a plasma nozzle, the plasma flow on the flexible substrate to create a conductive track on the flexible substrate, the plasma nozzle being at a distance between 1 and 50 mm with respect to the flexible substrate, thereby obtaining the electronic assembly.

This is an easy and very effective way of directly depositing a conductive track on a plastics substrate. This step may be carried out, for instance, using the device described in document US 2015/174686 A1, and concretely in its claim 1.

A method for manufacturing an electronic assembly using these parameters makes the conductive track be directly deposited on the flexible substrate without damaging it and ensuring correct electrical performance of the arrangement. The electronic assembly obtained by this method differs from those obtained by prior art methods in that a thin conductive track is arranged on a flexible substrate in a simple and inexpensive way.

In some particular embodiments, the metal dust is fed to the plasma flow at a rate comprised between 0.08 and 0.095 g/s, preferably between 0.08 and 0.085 g/s.

This flow rate is advantageous to achieve a good density of the conductive track.

In some particular embodiments, the plasma flow exits the plasma nozzle at a rate comprised between 0.58 and 1.33 l/s, preferably between 0.80 and 0.85 l/s.

This flow rate provides a good environment for the metal dust particles being deposited on the plastic substrate.

In some particular embodiments, the plasma nozzle is at a distance between 25 and 50 mm with respect to the flexible substrate.

This distance ensures correct deposition of the metal dust, forming an operative conductive track, but without damaging the flexible substrate.

In some particular embodiments, the electric power generated to create a plasma flow is comprised between 800 and 1200 W, preferably between 950 and 1050 W.

This power is suitable for create a plasma flow with energy enough to melt conductive metals.

In some particular embodiments, the frequency at which electric power is generated is comprised between 50 and 100 kHz, preferably between 60 and 65 kHz.

This frequency is suitable for creating a plasma flow which optimizes the metal melting and its deposition in the plastic substrate.

The suitable combination of these parameters improves the metal transfer coefficient, which should be understood in this specification as the ratio between the metal actually deposited on the plastic substrate and the metal dust which is fed into the plasma flow. The metal transfer coefficient should be improved but without excessively increasing temperature, as this would cause damage in the flexible substrate.

In some particular embodiments, the plasma flow comprises at least one of nitrogen, helium, neon, argon, krypton or xenon.

Inert gases as nitrogen or noble gases are preferred to avoid chemical reactions between melted metal and activated gases at plasma high temperatures where activated species are generated, obtaining non-electrical conductive oxides. It has been surprisingly found that the use of inert gases in the plasma deposition improves the final outcome, due to high temperatures, which would make other fluids react with melted metal.

In some particular embodiments, the flexible substrate contains at least one of acrylonitrile butadiene styrene, poly-carbonate, poly-propylene, plastics doped with glass fibre, talc or graphite, paper, acetate.

These materials are suitable for receiving a plasma dust when tuned with the suitable parameters as described above. These materials are flexible in the sense of this invention: two of its edges may be put together without causing a plastic deformation. This definition is consistent with the concept of "flexible circuit board", which belongs to the common general knowledge of the person skilled in the art.

In some particular embodiments, the flexible substrate contains a metal sheet covered by a non-conductive material.

This is an alternative option for obtaining a flexible substrate. Metal and non-conductive covers are usually easy to manufacture and inexpensive.

In some particular embodiments, the flexible substrate is between 0.2 and 2 mm thick. This range improves flexibility of the flexible substrate.

In another inventive aspect, the invention provides an electronic assembly manufactured by a method according to the previous inventive aspect, this electronic assembly comprising
a flexible substrate; and
a conductive track directly deposited on the flexible substrate.

Such an electronic assembly advantageously provides an electric connection of a semiconductor light source to a conductive track directly deposited on a flexible substrate.

In another inventive aspect, the invention provides a lighting device for automotive vehicle, the lighting device comprising
an electronic assembly according to the previous inventive aspect;
an optical element suitable for receiving light emitted by the light source and for shaping the light into a light pattern projected outside the lighting device; and
a housing accommodating the electronic assembly and the optical element.

An optical element is an element that has some optical properties to receive a light beam and emit it in a certain direction and/or shape, as a person skilled in automotive lighting would construe without any additional burden. Reflectors, collimators, light guides, projection lenses, etc., or the combination thereof are some examples of these optical elements.

Lighting devices for automotive vehicles can benefit from the use of electronic assemblies comprising conductive tracks directly deposited on a plastics substrate. In the first place, a wide range of the lighting device's parts can be used either as plastics substrate or as base for the plastics substrate (in which case the plastics substrate may for instance coat the base), taking into account that even three-dimensional plastics substrates are suitable for direct deposition of conductive tracks. Therefore, a dedicated printed board circuit is not required, which leads to reducing the cost and the weight of the lighting device. As was stated above, cost savings are even more significant due to the fact that direct deposition does not normally want removing conductive material to shape the conductive tracks.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figures 1a to 1c show some steps of a method for manufacturing an electronic assembly according to the invention.
Figure 2 shows an electronic assembly according to the invention.
Figure 3 shows a lighting device comprising an electronic assembly as shown in figure 2.

### DETAILED DESCRIPTION OF THE INVENTION

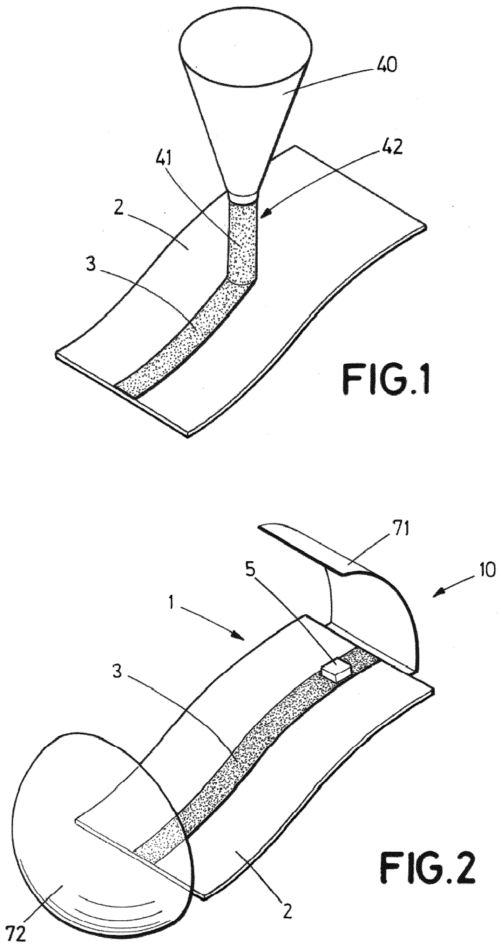

Figure 1 shows one of the steps of a method for manufacturing an electronic assembly according to the invention.

In this figure, a flexible substrate 2 has been provided, and a plasma flow 42 containing metal dust 41 is ejected by means of a plasma nozzle 40 on the plastics substrate 2 to create a conductive track 3.

The plasma flow 42 has been generated by an electric power comprised between 800 and 1200 W, generated at a frequency comprised between 50 and 100 kHz. Metal dust 41 has been fed to said plasma flow 42 at a rate comprised between 0.08 and 0.095 g/s.

The resulting plasma flow 42 with the metal dust 41 is made exit the plasma nozzle 40 at a rate comprised between 0.58 and 1.33 l/s.

When this plasma flow 42 with metal dust 41 impacts the flexible substrate 2, a conductive track 3 is formed on it. The electronic assembly 1 is therefore manufactured.

Figure 2 shows the manufacturing of a lighting device 10 out of this electronic assembly 1. In this figure, an electronic assembly 1 which has been manufactured according to a method partially shown in figure 1 is provided, and a semiconductor light source 5 has been added to this electronic assembly 1.

The final step includes the provision of some optical elements 71, 72 suitable for receiving light from the semiconductor light source 5 and projecting it in the shape of a pattern light in a forward direction.

The forward direction should be understood as the advance direction of an automotive vehicle where the lighting device is intended to be installed.

In the particular embodiment shown in this figure, the optical elements include a reflector 71 and a projection lens 72. The reflector 71 is placed in the electronic assembly 1, arranged to reflect the light emitted by the semiconductor light source 5. The projection lens 72 is in turn located in a forward position with respect to the lighting device 10, and receives the light from the semiconductor light source 5 which has been reflected by the reflector 71. The projection lens 72 orientates this received light according to the vehicle advancing direction.

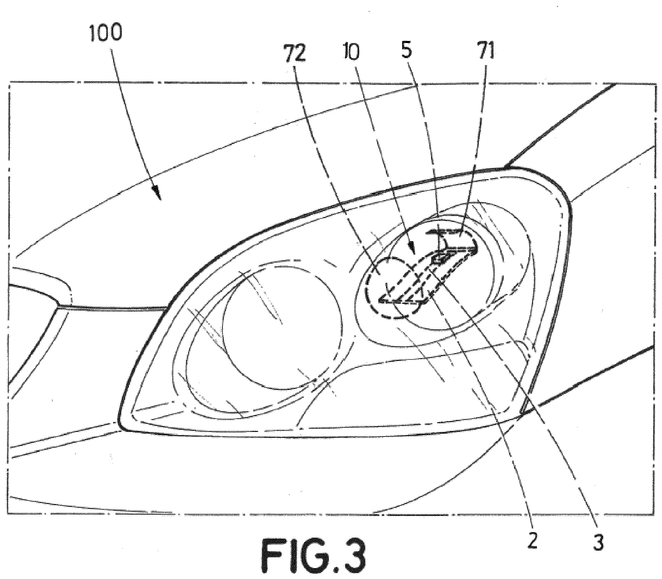

These optical elements 71, 72 makes the lighting device 10 suitable for being installed in an automotive vehicle 100 and able to perform lighting functions, such as high-beam and low-beam. Figure 3 shows such a lighting device 10 being installed in an automotive vehicle 100.

This lighting device 10 occupies a smaller volume than the lighting devices of the state of the art, since the flexible substrate is thinner than standard substrates and the directly deposited conductive tracks are also slimmer than traditional ones. This makes that the lighting device may be smaller or house more elements without the need of increasing its size. Further, this device is cheaper, since the flexible substrate has been obtained with a cheaper method and cheaper materials.

This lighting device 10 may be incorporated in an automotive vehicle 100, saving space and weight, because its manufacturing requires less time and a lower number of elements.

## Claims

1. Method for manufacturing an electronic assembly (1), the method comprising the steps of:
providing a flexible substrate (2); and
depositing a conductive track (3) by direct deposition on the flexible substrate (2), wherein the flexible substrate is flexible in the sense that two of its edges may be put together without causing a plastic deformation in said flexible substrate.

2. Method according to any of preceding claims, wherein the step of depositing a conductive track (3) by direct deposition on the flexible substrate (2) comprises the steps of:
- applying metal dust (41) within a plasma flow (42) created by an electric power, wherein the metal dust (41) is fed to the plasma flow (42) at a rate comprised between 0.08 and 0.095 g/s, the electric power generated to create a plasma flow (42) is comprised between 200 and 3500 W and the electric power is generated at a frequency comprised between 20 and 80 kHz;
- ejecting, by means of a plasma nozzle (40), the plasma flow (42) on the flexible substrate (2) to create a conductive track (3) on the flexible substrate (2), the plasma nozzle (40) being at a distance between 1 and 50 mm with respect to the flexible substrate (2), thereby obtaining the electronic assembly (1).

3. Method according to claim 2, wherein the metal dust (41) is fed to the plasma flow (42) at a rate comprised between 0.08 and 0.095 g/s, preferably between 0.08 and 0.085 g/s.

4. Method according to any of claims 2 or 3, wherein the plasma flow (42) exits the plasma nozzle (40) at a rate comprised between 0.58 and 1.33 l/s, preferably between 0.80 and 0.85 l/s.

5. Method according to any of claims 2 to 4, wherein the plasma nozzle (40) is at a distance between 25 and 50 mm with respect to the flexible substrate (2).

6. Method according to any of claims 2 to 5, wherein the electric power generated to create a plasma flow (42) is comprised between 800 and 1200 W, preferably between 950 and 1050 W.

7. Method according to any of claims 2 to 6, wherein the frequency at which electric power is generated is comprised between 50 and 100 kHz, preferably between 60 and 65 kHz.

8. Method according to any of preceding claims, wherein the plasma flow (42) comprises at least one of nitrogen, helium, neon, argon, krypton or xenon.

9. Method according to any of preceding claims, wherein the flexible substrate (2) contains at least one of acrylonitrile butadiene styrene, poly-carbonate, poly-propylene, plastics doped with glass fibre, talc or graphite, paper, acetate.

10. Method according to any of preceding claims, wherein the flexible substrate (2) contains a metal sheet covered by a non-conductive material.

11. Method according to any of preceding claims, wherein the flexible substrate (2) is between 0.2 and 2 mm thick.

12. Electronic assembly (1) manufactured by a method according to any of preceding claims comprising
a flexible substrate (2); and
a conductive track (3) directly deposited on the flexible substrate (2).

13. Lighting device (10) for automotive vehicle (100), the lighting device (10) comprising
an electronic assembly (1) according to claim 12;
an optical element (71, 72) suitable for receiving light emitted by the light source (5) and for shaping the light into a light pattern projected outside the lighting device (10); and
a housing (12) accommodating the electronic assembly (1) and the optical element (71, 72).
